# EUROPÄISCHE PATENTSCHRIFT

(11) **EP 2 630 273 B1**
(45) Veröffentlichungstag und Bekanntmachung des Hinweises auf die Patenterteilung: **08.05.2019**
(21) Anmeldenummer: 11788021.1
(22) Anmeldetag: 01.09.2011
(51) Int. Cl.: C23C 16/26, C23C 16/40, C23C 16/503, C23C 16/511, C23C 16/515, C23C 16/52, B65D 23/02, C23C 16/04, C23C 16/02

(54) **VERFAHREN ZUR PLASMABEHANDLUNG VON WERKSTÜCKEN**
METHOD FOR PLASMA-TREATING WORKPIECES
PROCÉDÉ DE TRAITEMENT AU PLASMA DE PIÈCES

(30) Priorität: 18.10.2010 DE 102010048960
(43) Veröffentlichungstag der Anmeldung: 28.08.2013
(73) Patentinhaber: KHS Corpoplast GmbH, 22145 Hamburg (DE)
(72) Erfinder: SIEBELS, Sönke, 22303 Hamburg (DE); KYTZIA, Sebastian, 22301 Hamburg (DE)
(74) Vertreter: Emmel, Thomas
(86) Internationale Anmeldenummer: PCT/DE2011/001691
(87) Internationale Veröffentlichungsnummer: WO 2012/051975

(56) Entgegenhaltungen:
- EP-A1- 0 718 418
- EP-A1- 1 561 840
- EP-A1- 1 630 848
- EP-A1- 1 921 656
- EP-A2- 1 921 179
- DE-A1- 10 258 678
- US-A- 5 395 453

## Beschreibung

Die Erfindung betrifft ein Verfahren zur Plasmabehandlung von Werkstücken, bei dem das Werkstück in eine Plasmakammer eingesetzt wird und bei dem anschließend bei Einwirkung eines Unterdruckes nach der Zündung eines Plasmas eine Beschichtung auf dem Werkstück abgeschieden wird sowie bei dem die Zündung des Plasmas durch gepulste Mikrowellenenergie erfolgt, wobei von einer Steuerung alternierend Einschaltphasen und Ausschaltphasen einer Mikrowellenenergieeinkopplung vorgegeben werden.

Die Anmeldung betrifft darüber hinaus eine Vorrichtung zur Plasmabehandlung von Werkstücken, die mindestens eine evakuierbare Plasmakammer zur Aufnahme der Werkstücke aufweist und bei der die Plasmakammer im Bereich einer Behandlungsstation angeordnet ist, sowie bei der die Plasmakammer von einem Kammerboden, einem Kammerdeckel sowie einer seitlichen Kammerwandung begrenzt ist und bei der die Plasmakammer mit einer Einrichtung zur Zündung des Plasmas durch gepulste Mikrowellenenergie gekoppelt ist, wobei eine Steuereinrichtung für eine Steuerung der Einkopplung der Mikrowellenenergie zur alternierenden Generierung von Einschaltphasen und Ausschaltphasen der Mikrowelleneinkopplung ausgebildet ist.

Derartige Verfahren und Vorrichtungen werden beispielsweise eingesetzt, um Kunststoffe mit Oberflächenbeschichtungen zu versehen. Insbesondere sind auch bereits derartige Vorrichtungen bekannt, um innere oder äußere Oberflächen von Behältern zu beschichten, die zur Verpackung von Flüssigkeiten vorgesehen sind. Darüber hinaus sind Einrichtungen zur Plasmasterilisation bekannt.

In der PCT-WO 95/22413 wird eine Plasmakammer zur Innenbeschichtung von Flaschen aus PET beschrieben. Die zu beschichtenden Flaschen werden durch einen beweglichen Boden in eine Plasmakammer hineingehoben und im Bereich einer Flaschenmündung mit einem Adapter in Verbindung gebracht. Durch den Adapter hindurch kann eine Evakuierung des Flascheninnenraumes erfolgen. Darüber hinaus wird durch den Adapter hindurch eine hohle Gaslanze in den Innenraum der Flaschen eingeführt, um Prozeßgas zuzuführen. Eine Zündung des Plasmas erfolgt unter Verwendung einer Mikrowelle.

Aus dieser Veröffentlichung ist es auch bereits bekannt, eine Mehrzahl von Plasmakammern auf einem rotierenden Rad anzuordnen. Hierdurch wird eine hohe Produktionsrate von Flaschen je Zeiteinheit unterstützt.

In der EP-OS 10 10 773 wird eine Zuführeinrichtung erläutert, um einen Flascheninnenraum zu evakuieren und mit Prozeßgas zu versorgen. In der PCT-WO 01/31680 wird eine Plasmakammer beschrieben, in die die Flaschen von einem beweglichen Deckel eingeführt werden, der zuvor mit einem Mündungsbereich der Flaschen verbunden wurde.

Die PCT-WO 00/58631 zeigt ebenfalls bereits die Anordnung von Plasmastationen auf einem rotierenden Rad und beschreibt für eine derartige Anordnung eine gruppenweise Zuordnung von Unterdruckpumpen und Plasmastationen, um eine günstige Evakuierung der Kammern sowie der Innenräume der Flaschen zu unterstützen. Darüber hinaus wird die Beschichtung von mehreren Behältern in einer gemeinsamen Plasmastation bzw. einer gemeinsamen Kavität erwähnt.

Eine weitere Anordnung zur Durchführung einer Innenbeschichtung von Flaschen wird in der PCT-WO 99/17334 beschrieben. Es wird hier insbesondere eine Anordnung eines Mikrowellengenerators oberhalb der Plasmakammer sowie eine Vakuum- und Betriebsmittelzuleitung durch einen Boden der Plasmakammer hindurch beschrieben.

In der DE 10 2004 020 185 A1 wird bereits eine Gaslanze beschrieben, die in den Innenraum eines zu beschichtenden Vorformlings einfahrbar ist und zur Zuleitung von Prozeßgasen dient. Die Gaslanze ist in der Längsrichtung des Behälters positionierbar.

Bei der überwiegenden Anzahl der bekannten Vorrichtungen werden zur Verbesserung von Barriereeigenschaften des thermoplastischen Kunststoffmaterials durch das Plasma erzeugte Behälterschichten aus Siliziumoxiden mit der allgemeinen chemischen Formel SiOx verwendet. Derartige Barriereschichten verhindern ein Eindringen von Sauerstoff in die verpackten Flüssigkeiten sowie ein Austreten von Kohlendioxid bei CO₂-haltigen Flüssigkeiten.

In der WO 03/014412 A1 wird die Durchführung eines Plasmabeschichtungsverfahren beschrieben, bei dem die erforderliche Energieeinbringung durch gepulste Mikrowellenenergie erfolgt. Für die gesamte Durchführung des Beschichtungsvorganges wird eine geeignete Pulsbreite und Pulshöhe für die Mikrowellenenergie gewählt. Ebenfalls werden Pausenzeiten zwischen den einzelnen Impulsen festgelegt und für die Dauer der Beschichtung konstant gehalten. Variiert wird gemäß diesem Stand der Technik bei der Durchführung des Beschichtungsvorganges der Volumenstrom an zugeführten Prozeßgasen sowie die Mischung der Prozeßgase. Typischerweise werden die Mischungsverhältnisse und/oder die jeweiligen Volumenströme der Prozeßgase zu bestimmten Zeitpunkten umgeschaltet, so daß sich ein mehrlagiger Schichtaufbau ergibt. Bei Aufbringung von Barriereschichten aus SiOx auf ein Substrat aus Kunststoff werden typischerweise zwei Schichten generiert, nämlich eine Haftschicht und die eigentliche Barriereschicht. Anwendungsabhängig kann auf der Barriereschicht noch eine zusätzliche Schutzschicht angeordnet werden.

Die erforderliche Veränderung der Volumenströme beziehungsweise der Zusammensetzungen der Prozeßgase erfordert eine vergleichsweise komplexe Ventilsteuerung. Darüber hinaus führen entsprechende Steueroperationen nicht unmittelbar zu einer Auswirkung auf den Prozeß, da aufgrund von vorliegenden Leitungslängen und Restgasmengen im Ventilbereich Verzögerungen zu berücksichtigen sind.

Die EP 0 718 418 beschreibt ein Verfahren, bei dem in einer Plasmakammer mittels Plasma eine Beschichtung auf ein Werkstück aufgebracht wird. Die Zündung des Plasmas erfolgt durch gepulste Mikrowellenenergie, und es ist eine Steuerung vorgesehen, die die Ein- und Ausschaltphasen einer Mikrowelleneinkopplung alternierend vorgibt. Durch Veränderung der Relation zwischen den beiden Phasen kann eine Schicht erzeugt werden, die z.B. einen Kohlenstoffgradienten aufweist.

Ähnliche Verfahren werden in der EP 1 630 848, EP 1 561 840 A1 und der EP 1 921 179 beschrieben. Auch hier werden die Relationen zwischen Ein- und Ausschaltzeiten einer Mikrowelleneinkopplung variiert.

Aufgabe der vorliegenden Erfindung ist es daher, ein Verfahren der einleitend genannten Art derart zu verbessern, daß eine optimierte Barriereschicht erzeugt wird.

Wie bei bekannten Verfahren wird während der Durchführung des Behandlungsvorganges für ein Werkstück die Relation zwischen der Dauer der Einschalt - phasen und der Dauer der Ausschaltphasen verändert wird.

Durch die Möglichkeit zur Veränderung der zeitlichen Relation zwischen den Einschaltphasen und den Ausschaltphasen der gepulsten Mikrowellenenergie wird eine zusätzliche Möglichkeit zur Beeinflussung des Beschichtungsvorganges bereitgestellt. Insbesondere ist es möglich, ohne eine Veränderung der Zusammensetzung der Prozeßgase und/oder der Volumenströme der zugeführten Prozeßgase oder zumindest bei einer verminderten derartigen Einwirkung auf den Prozeß eine äußerst effektive Steuerung durchzuführen. Es wurde erkannt , daß insbesondere durch die Veränderung der im zeitlichen Mittel eingebrachten Energie signifikant das Abscheideverhalten der Prozeßgase verändert werden kann. Beispielsweise zeigt es sich, daß bei einer geringen mittleren Energieeinbringung und somit bei vergleichsweise kurzen Einschaltphasen der Mikrowellenengerie eine erhöhte Menge an Kohlenstoff abgeschieden wird. Bei der Verwendung von Prozeßgasen, die Silizium, Sauerstoff und Kohlenstoff enthalten, nimmt mit zunehmender Intensität der Energieeinbringung die Abseheidung von SiOx zu und damit der Kohlenstoffanteil der abgeschiedenen Schicht ab. Ähnliche Effekte zeigen sich auch bei andersartigen Zusammensetzungen der Prozeßgase.

Eine Beeinflussung von Hafteigenschaften und/oder der chemischen Beständigkeit gegenüber einer Einwirkung von sauren oder alkalischen Medien wird dadurch erreicht, daß die Barriereschicht über eine Schichtdicke mit einem veränderlichen Kohlenstoffanteil versehen wird.

Sowohl die Bereitstellung einer Haftschicht als auch einer Schutzschicht wird erfindungsgemäß dadurch unterstützt, daß ein Kohlenstoffanteil in der Barriereschicht ausgehend vom Werkstück über die Schichtdicke zunächst vermindert und in einem dem Werkstück abgewandten Bereich wieder vergrößert wird.

Steuerungstechnisch wird die Generierung sowohl einer Haftschicht als auch einer Schutzschicht erfindungsgemäß dadurch erreicht, daß der Quotient aus der Einschaltzeit und der Ausschaltzeit während der Dauer des Beschichtungsvorganges zunächst vergrößert und anschließend wieder verkleinert wird.

Zur Gewährleistung der Zufuhr einer ausreichenden Menge an Prozeßgasen wird vorgeschlagen, daß mindestens während eines Teiles der Dauer der Plasmabehandlung die Dauer der Ausschaltzeit zwischen zwei Einschaltzeiten konstant gehalten wird.

Eine typische Verfahrensdurchführung wird dadurch definiert, daß die Ausschaltzeit etwa 30 Millisekunden beträgt.

Darüber hinaus ist daran gedacht, daß die Einschaltzeit zu einem Beginn der Plasmabehandlung etwa 0,3 Millisekunden beträgt.

Ebenfalls erweist es sich als zweckmäßig, daß die Einschaltzeit zu einem Ende der Plasmabehandlung etwa 0,3 Millisekunden beträgt.

Eine über die Schichtdicke kontinuierliche Parameterveränderung wird dadurch erreicht, daß die Einschaltzeiten während der Dauer des Behandlungsvorganges kontinuierlich vergrößert werden.

Gemäß einer bevorzugten Ausführungsform ist daran gedacht, daß als Werkstück ein flaschenartiger Behälter mit einer Barriereschicht versehen wird.

Eine transparente Barriereschicht mit guten Barriereeigenschaften wird dadurch bereitgestellt, daß als Barriereschicht eine Schicht verwendet wird, die SiOx enthält.

Weiterhin beschrieben ist eine Vorrichtung der einleitend genannten Art, die eine einfache und zugleich schnelle Prozeßsteuerung ermöglicht.

Dies wird dadurch erreicht, daß die Steuereinrichtung während der Durchführung des Behandlungsvorganges für ein Werkstück die Relation zwischen der Dauer der Einschaltphasen und der Dauer der Ausschaltphasen verändert. Das erfindungsgemäße Verfahren sowie die beschriebene Vorrichtung sind insbesondere dafür geeignet, den Ablauf eines Beschichtungsverfahrens für Flaschen aus Kunststoff
zu steuern. Es erfolgt hierbei insbesondere eine Innenbeschichtung dieser Flaschen mit einer Schicht aus SiOx, wobei die Haftung der Schicht aus SiOx auf dem Kunststoff durch eine Zwischenschicht verbessert werden kann, die als ein Haftvermittler ausgebildet ist. Das Beschichtungsverfahren wird vorzugsweise als ein PICVD-Plasmaprozess durchgeführt (Plasma impuls induced chemical vapour deposition). Bei einem derartigen Verfahren wird das Plasma unter Verwendung von Pulsen einer Mikrowelle gezündet. Die Pulse können hinsichtlich ihrer Pulsbreite, des Pulsabstandes sowie der Pulshöhe gesteuert werden.

In den Zeichnungen sind Ausführungsbeispiele der Erfindung schematisch dargestellt. Es zeigen:
- Fig. 1: Eine Prinzipskizze einer Mehrzahl von Plasmakammern, die auf einem rotierenden Plasmarad angeordnet sind und bei der das Plasmarad mit Eingabe- und Ausgaberädern gekoppelt ist,
- Fig. 2: eine Anordnung ähnlich zu Fig. 1, bei der die Plasmastationen jeweils mit zwei Plasmakammern ausgestattet sind,
- Fig. 3: eine perspektivische Darstellung eines Plasmarades mit einer Vielzahl von Plasmakammern,
- Fig. 4: eine perspektivische Darstellung einer Plasmastation mit einer Kavität,
- Fig. 5: eine Vorderansicht der Vorrichtung gemäß Fig. 4 mit geschlossener Plasmakammer,
- Fig. 6: einen Querschnitt gemäß Schnittlinie VI-VI in Fig. 5,
- Fig. 7: eine teilweise Darstellung eines Querschnittes durch ein Substrat mit einer Barriereschicht,
- Fig. 8: ein Diagramm zur Veranschaulichung unterschiedlicher Pulsbreiten einer gepulsten Einspeisung von Mikrowellenenergie und
- Fig. 9: einen stark vergrößerten Querschnitt durch eine Barriereschicht mit über die Schichtdicke veränderlichem Kohlenstoffgehalt.

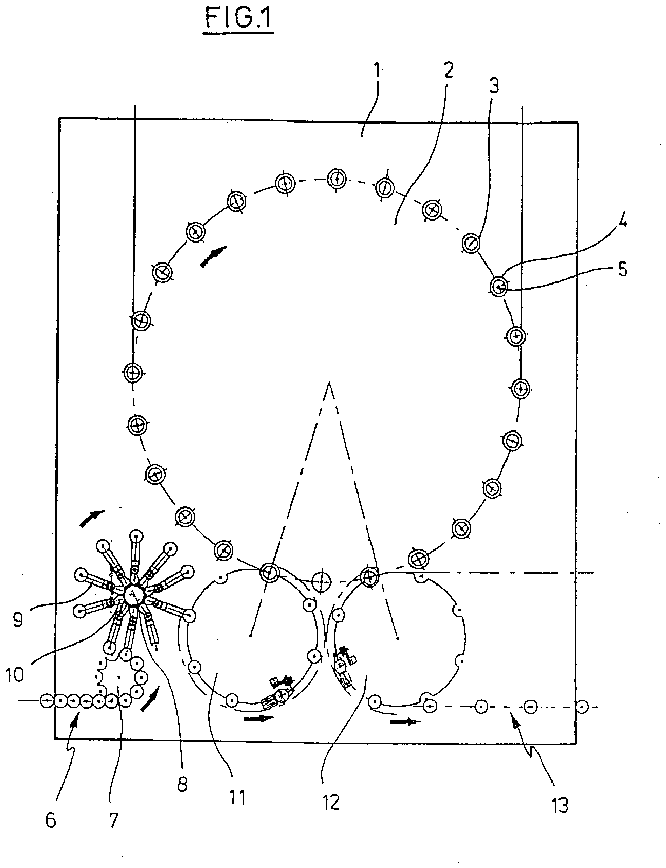

Aus der Darstellung in Fig. 1 ist ein Plasmamodul (1) zu erkennen, das mit einem rotierenden Plasmarad (2) versehen ist. Entlang eines Umfanges des Plasmarades (2) sind eine Mehrzahl von Plasmastationen (3) angeordnet. Die Plasmastationen (3) sind mit Kavitäten (4) bzw. Plasmakammern (17) zur Aufnahme von zu behandelnden Werkstücken (5) versehen.

Die zu behandelnden Werkstücke (5) werden dem Plasmamodul (1) im Bereich einer Eingabe (6) zugeführt und über ein Vereinzelungsrad (7) an ein Übergaberad (8) weitergeleitet, das mit positionierbaren Tragarmen (9) ausgestattet ist. Die Tragarme (9) sind relativ zu einem Sockel (10) des Übergaberades (8) verschwenkbar angeordnet, so daß eine Abstandsveränderung der Werkstücke (5) relativ zueinander durchgeführt werden kann. Hierdurch erfolgt eine Übergabe der Werkstücke (5) vom Übergaberad (8) an ein Eingaberad (11) mit einem relativ zum Vereinzelungsrad (7) vergrößerten Abstand der Werkstücke (5) relativ zueinander. Das Eingaberad (11) übergibt die zu behandelnden Werkstücke (5) an das Plasmarad (2). Nach einer Durchführung der Behandlung werden die behandelten Werkstücke (5) von einem Ausgaberad (12) aus dem Bereich des Plasmarades (2) entfernt und in den Bereich einer Ausgabestrecke (13) überführt.

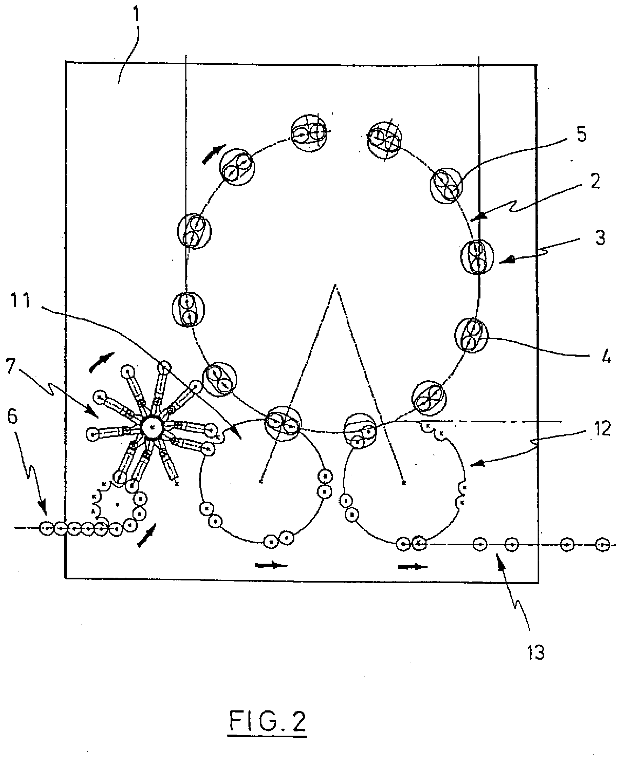

Bei der Ausführungsform gemäß Fig. 2 sind die Plasmastationen (3) jeweils mit zwei Kavitäten (4) bzw. Plasmakammern (17) ausgestattet. Hierdurch können jeweils zwei Werkstücke (5) gleichzeitig behandelt werden. Grundsätzlich ist es hierbei möglich, die Kavitäten (4) vollständig voneinander getrennt auszubilden, grundsätzlich ist es aber auch möglich, in einem gemeinsamen Kavitätenraum lediglich Teilbereiche derart gegeneinander abzugrenzen, daß eine optimale Beschichtung aller Werkstücke (5) gewährleistet ist. Insbesondere ist hierbei daran gedacht, die Teilkavitäten zumindest durch separate Mikrowelleneinkopplungen gegeneinander abzugrenzen.

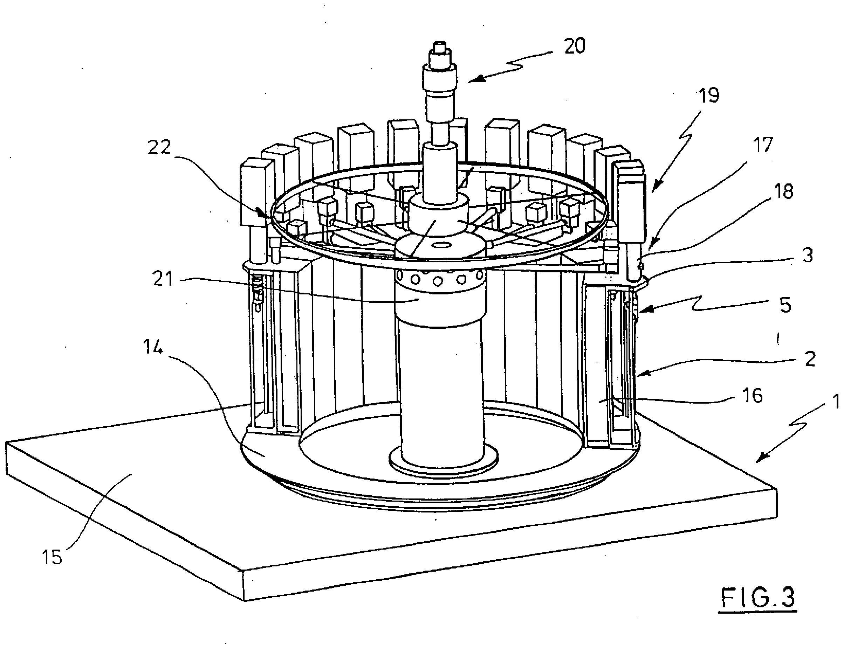

Fig. 3 zeigt eine perspektivische Darstellung eines Plasmamoduls (1) mit teilweise aufgebautem Plasmarad (2). Die Plasmastationen (3) sind auf einem Tragring (14) angeordnet, der als Teil einer Drehverbindung ausgebildet und im Bereich eines Maschinensockels (15) gelagert ist. Die Plasmastationen (3) weisen jeweils einen Stationsrahmen (16) auf, der Plasmakammern (17) haltert. Die Plasmakammern (17) weisen zylinderförmige Kammerwandungen (18) sowie Mikrowellengeneratoren (19) auf.

In einem Zentrum des Plasmarades (2) ist ein Drehverteiler (20) angeordnet, über den die Plasmastationen (3) mit Betriebsmitteln sowie Energie versorgt werden. Zur Betriebsmittelverteilung können insbesondere Ringleitungen (21) eingesetzt werden.

Die zu behandelnden Werkstücke (5) sind unterhalb der zylinderförmigen Kammerwandungen (18) dargestellt. Unterteile der Plasmakammern (17) sind zur Vereinfachung jeweils nicht eingezeichnet.

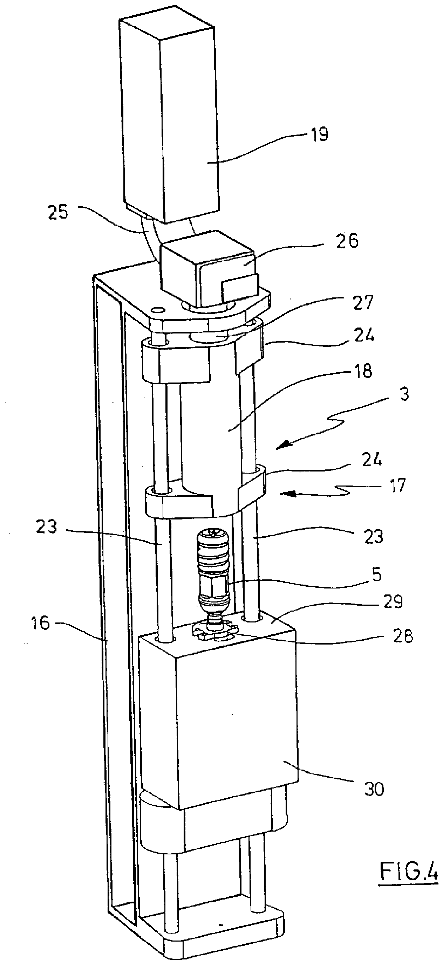

Fig. 4 zeigt eine Plasmastation (3) in perspektivischer Darstellung. Es ist zu erkennen, daß der Stationsrahmen (16) mit Führungsstangen (23) versehen ist, auf denen ein Schlitten (24) zur Halterung der zylinderförmigen Kammerwandung (18) geführt ist. Fig. 4 zeigt den Schlitten (24) mit Kammerwandung (18) in einem angehobenen Zustand, so daß das Werkstück (5) freigegeben ist.

Im oberen Bereich der Plasmastation (3) ist der Mikrowellengenerator (19) angeordnet. Der Mikrowellengenerator (19) ist über eine Umlenkung (25) und einen Adapter (26) an einen Kopplungskanal (27) angeschlossen, der in die Plasmakammer (17) einmündet. Grundsätzlich kann der Mikrowellengenerator (19) sowohl unmittelbar im Bereich des Kammerdeckels (31) als auch über ein Distanzelement an den Kammerdeckel (31) angekoppelt mit einer vorgebbaren Entfernung zum Kammerdeckel (31) und somit in einem größeren Umgebungsbereich des Kammerdeckels (31) angeordnet werden. Der Adapter (26) hat die Funktion eines Übergangselementes und der Kopplungskanal (27) ist als ein Koaxialleiter ausgebildet. Im Bereich einer Einmündung des Kopplungskanals (27) in den Kammerdeckel (31) ist ein Quarzglasfenster angeordnet. Die Umlenkung (25) ist als ein Hohlleiter ausgebildet.

Das Werkstück (5) wird von einem Halteelement (28) positioniert, das im Bereich eines Kammerbodens (29) angeordnet ist. Der Kammerboden (29) ist als Teil eines Kammersockels (30) ausgebildet. Zur Erleichterung einer Justage ist es möglich, den Kammersockel (30) im Bereich der Führungsstangen (23) zu fixieren. Eine andere Variante besteht darin, den Kammersockel (30) direkt am Stationsrahmen (16) zu befestigen. Bei einer derartigen Anordnung ist es beispielsweise auch möglich, die Führungsstangen (23) in vertikaler Richtung zweiteilig auszuführen.

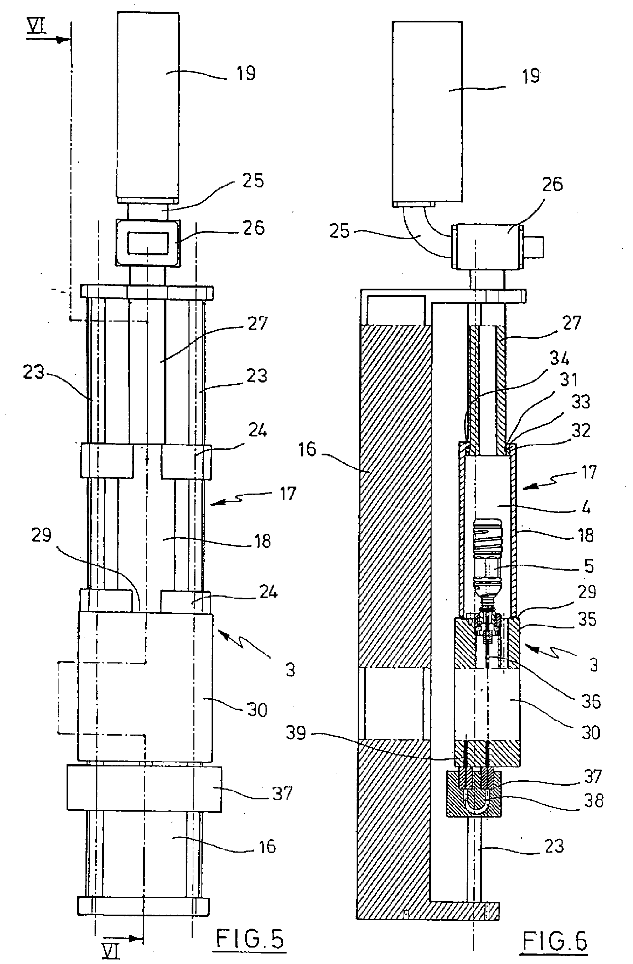

Fig. 5 zeigt eine Vorderansicht der Plasmastation (3) gemäß Fig. 3 in einem geschlossenen Zustand der Plasmakammer (17). Der Schlitten (24) mit der zylinderförmigen Kammerwandung (18) ist hierbei gegenüber der Positionierung in Fig. 4 abgesenkt, so daß die Kammerwandung (18) gegen den Kammerboden (29) gefahren ist. In diesem Positionierzustand kann die Plasmabeschichtung durchgeführt werden.

Fig. 6 zeigt in einer Vertikalschnittdarstellung die Anordnung gemäß Fig. 5. Es ist insbesondere zu erkennen, daß der Kopplungskanal (27) in einen Kammerdeckel (31) einmündet, der einen seitlich überstehenden Flansch (32) aufweist. Im Bereich des Flansches (32) ist eine Dichtung (33) angeordnet, die von einem Innenflansch (34) der Kammerwandung (18) beaufschlagt wird. In einem abgesenkten Zustand der Kammerwandung (18) erfolgt hierdurch eine Abdichtung der Kammerwandung (18) relativ zum Kammerdeckel (31). Eine weitere Dichtung (35) ist in einem unteren Bereich der Kammerwandung (18) angeordnet, um auch hier eine Abdichtung relativ zum Kammerboden (29) zu gewährleisten.

In der in Fig. 6 dargestellten Positionierung umschließt die Kammerwandung (18) die Kavität (4), so daß sowohl ein Innenraum der Kavität (4) als auch ein Innenraum des Werkstückes (5) evakuiert werden können. Zur Unterstützung einer Zuleitung von Prozeßgas ist im Bereich des Kammersockels (30) eine hohle Gaslanze (36) angeordnet, die in den Innenraum des Werkstückes (5) hineinverfahrbar ist. Zur Durchführung einer Positionierung der Gaslanze (36) wird diese von einem Lanzenschlitten (37) gehaltert, der entlang der Führungsstangen (23) positionierbar ist. Innerhalb des Lanzenschlittens (37) verläuft ein Prozeßgaskanal (38), der in der in Fig. 6 dargestellten angehobenen Positionierung mit einem Gasanschluß (39) des Kammersockels (30) gekoppelt ist. Durch diese Anordnung werden schlauchartige Verbindungselemente am Lanzenschlitten (37) vermieden.

Alternativ zur vorstehend erläuterten Konstruktion der Plasmastation ist es erfindungsgemäß aber auch möglich, das Werkstück (5) in eine relativ zur zugeordneten Tragstruktur unbewegliche Plasmakammer (17) einzuführen. Ebenfalls ist es möglich, alternativ zur dargestellten Beschichtung der Werkstücke (5) mit ihren Mündungen in lotrechter Richtung nach unten eine Beschichtung der Werkstücke mit ihren Mündungen in lotrechter Richtung nach oben durchzuführen. Insbesondere ist daran gedacht, eine Beschichtung von flaschenförmigen Werkstücken (5) durchzuführen. Derartige Flaschen sind ebenfalls bevorzugt aus einem thermoplastischen Kunststoff ausgebildet. Vorzugsweise ist an die Verwendung von PET oder PP gedacht. Gemäß einer weiteren bevorzugten Ausführungsform dienen die beschichteten Flaschen zur Aufnahme von Getränken.

Ein typischer Behandlungsvorgang wird im folgenden am Beispiel eines Beschichtungsvorganges erläutert und derart durchgeführt, daß zunächst das Werkstück (5) unter Verwendung des Eingaberades (11) zum Plasmarad (2) transportiert wird und daß in einem hochgeschobenen Zustand der hülsenartigen Kammerwandung (18) das Einsetzen des Werkstückes (5) in die Plasmastation (3) erfolgt. Nach einem Abschluß des Einsetzvorganges wird die Kammerwandung (18) in ihre abgedichtete Positionierung abgesenkt und zunächst gleichzeitig eine Evakuierung sowohl der Kavität (4) als auch eines Innenraumes des Werkstückes (5) durchgeführt.

Nach einer ausreichenden Evakuierung des Innenraumes der Kavität (4) wird die Lanze (36) in den Innenraum des Werkstückes (5) eingefahren und durch eine Verschiebung des Halteelementes (28) eine Abschottung des Innenraumes des Werkstückes (5) gegenüber dem Innenraum der Kavität (4) durchgeführt. Ebenfalls ist es möglich, die Gaslanze (36) bereits synchron zur beginnenden Evakuierung des Innenraumes der Kavität in das Werkstück (5) hinein zu verfahren. Der Druck im Innenraum des Werkstückes (5) wird anschließend noch weiter abgesenkt. Darüber hinaus ist auch daran gedacht, die Positionierbewegung der Gaslanze (36) wenigstens teilweise bereits parallel zur Positionierung der Kammerwandung (18) durchzuführen. Nach Erreichen eines ausreichend tiefen Unterdruckes wird Prozeßgas in den Innenraum des Werkstückes (5) eingeleitet und mit Hilfe des Mikrowellengenerators (19) das Plasma gezündet. Insbesondere ist daran gedacht, mit Hilfe des Plasmas sowohl einen Haftvermittler auf eine innere Oberfläche des Werkstückes (5) als auch die eigentliche Barriereschicht aus Siliziumoxiden abzuscheiden.

Nach einem Abschluß des Beschichtungsvorganges wird die Gaslanze (36) wieder aus dem Innenraum des Werkstückes (5) entfernt und die Plasmakammer (17) sowie der Innenraum des Werkstückes (5) werden belüftet. Nach Erreichen des Umgebungsdruckes innerhalb der Kavität (4) wird die Kammerwandung (18) wieder angehoben, um eine Entnahme des beschichteten Werkstückes (5) sowie eine Eingabe eines neuen zu beschichtenden Werkstückes (5) durchzuführen.

Eine Positionierung der Kammerwandung (18), des Dichtelementes (28) und / oder der Gaslanze (36) kann unter Verwendung unterschiedlicher Antriebsaggregate erfolgen. Grundsätzlich ist die Verwendung pneumatischer Antriebe und / oder elektrischer Antriebe, insbesondere in einer Ausführungsform als Linearmotor, denkbar. Insbesondere ist aber daran gedacht, zur Unterstützung einer exakten Bewegungskoordinierung mit einer Rotation des Plasmarades (2) eine Kurvensteuerung zu realisieren. Die Kurvensteuerung kann beispielsweise derart ausgeführt sein, daß entlang eines Umfanges des Plasmarades (2) Steuerkurven angeordnet sind, entlang derer Kurvenrollen geführt werden. Die Kurvenrollen sind mit den jeweils zu positionierenden Bauelementen gekoppelt.

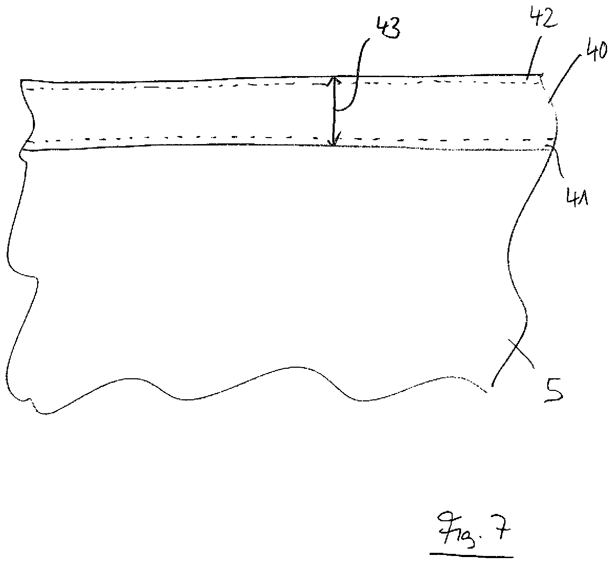

Fig. 7 zeigt eine teilweise Darstellung eines vergrößerten Querschnittes durch ein Werkstück (5), das mit einer Barriereschicht (40) versehen ist. Typischerweise ist die Barriereschicht (40) auf einer Wandung eines flaschenförmigen Behälters angeordnet. Insbesondere besteht das Werkstück (5) aus PET. Vorzugsweise ist die Barriereschicht (40) über eine Haftschicht (41) mit dem Werkstück (5) verbunden. Darüber hinaus ist es möglich, die Barriereschicht (40) im Bereich ihrer dem Werkstück (5) abgewandten Ausdehnung mit einer Schutzschicht (42) zu versehen.

Grundsätzlich können die Haftschicht (41) und/oder die Schutzschicht (42) als von der Barriereschicht (40) abgegrenzte Schichten ausgebildet sein, insbesondere ist aber daran gedacht, sogenannte Gradientenschichten zu realisieren, bei denen eine schichtartige Wirkung durch eine Veränderung der elementaren Zusammensetzung über eine Schichtdicke (43) erreicht wird. Hierdurch werden sogenannte Gradientenschichten bereitgestellt. Betroffen von der Änderung der elementaren Zusammensetzung ist mindestens eines der chemischen Elemente Kohlenstoff, Silizium sowie Sauerstoff. Grundsätzlich können aber auch andere chemische Elemente zusätzlich oder alternativ verwendet werden.

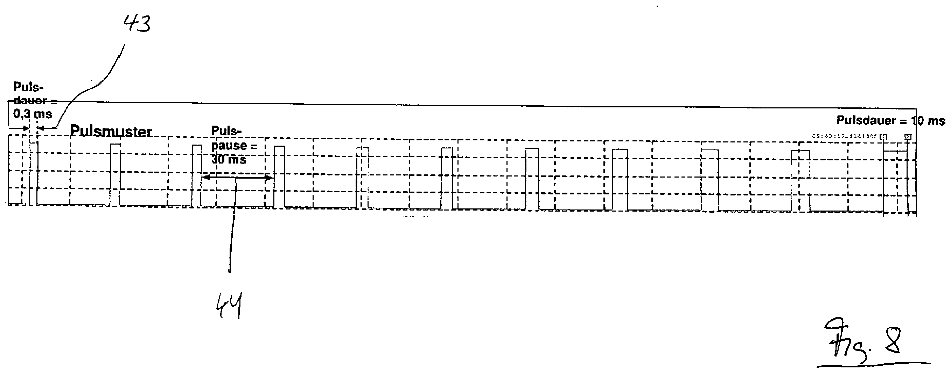

Fig. 8 veranschaulicht einen zeitlichen Verlauf einer gepulsten Mikrowelleneinspeisung zur Zündung des Plasmas. Während der Dauer der Beschichtung des Werkstückes (5) und somit während der Dauer des Aufbaues der Barriereschicht (40) wird hier das Verhältnis zwischen Einschaltzeiten (43) der Mikrowellenenergie und Ausschaltzeiten (44) der Mikrowellenenergie verändert. Das dargestellte Ausführungsbeispiel zeigt einer Veränderung derart, daß bei konstanten Ausschaltzeiten (44) die Dauer der Einschaltzeiten (43) verändert wird. Es ist hierbei an konstante Ausschaltzeiten (44) von bevorzugt 30 Millisekunden gedacht. Ein realisierbarer Bereich liegt zwischen 10 Millisekunden und 100 Millisekunden, bevorzugt zwischen 20 Millisekunden und 40 Millisekunden.

Eine zum Prozeßbeginn realisierte Einschaltzeit beträgt bei dem Ausführungsbeispiel etwa 0,3 Millisekunden. Die Einschaltzeit zum Prozeßende beträgt etwa 10 Millisekunden. Es erfolgt somit über die Prozeßdauer etwa eine Verdreißigfachung der Einschaltzeit (43).

Insbesondere ist daran gedacht, während der Dauer des Beschichtungsprozesses kontinuierlich die Einschaltzeit (43) zu vergrößern. Ein Auftrag der Einschaltzeiten (43) über die Prozeßzeit führt somit zu einem abgestuften rampenartigen Verlauf.

Eine typische Puls-Leistung der Mikrowelle beträgt etwa 1500 Watt. Ein typischer Prozeßdruck liegt zwischen 0,2 und 0,5 mbar. Als Prozeßgas wird bevorzugt HMDSN verwendet. Ein typischer Fluss liegt hier je Doppelreaktor in der Beschichtungsphase im Bereich von 5 - 10 sccm. Als oxidierendes Gas kann Sauerstoff zugeführt werden. Hier liegt ein typischer Fluss im Bereich von 300 - 800 sccm. Eine mittlere Leistung der Mikrowelle liegt zum Prozeßbeginn im Bereich von 20 - 100 Watt und zum Prozeßende im Bereich von 200 - 600 Watt.

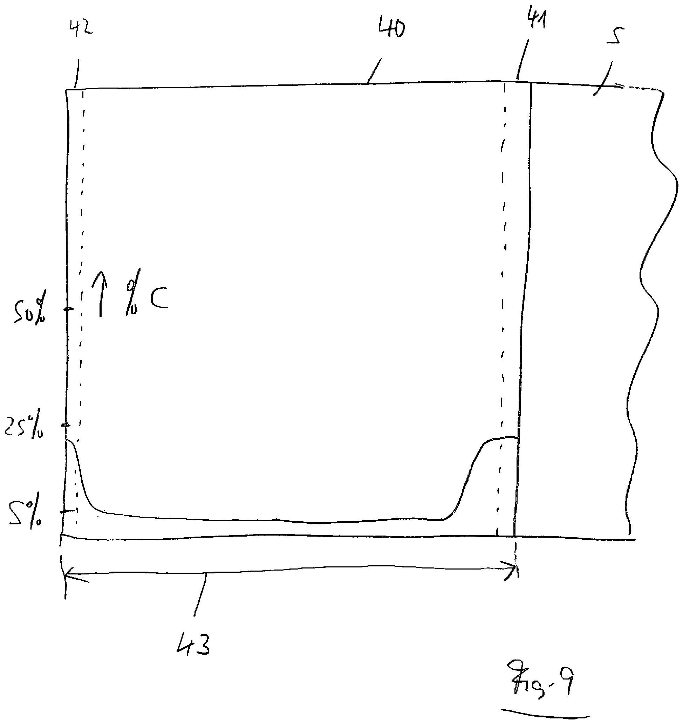

Fig. 9 zeigt einen weiteren vergrößerten teilweisen Querschnitt durch ein Werkstück (5) mit Barriereschicht (40). Zusätzlich ist ein Verlauf der Kohlenstoffkonzentration über die Schichtdicke (43) in Elementprozent eingetragen.

Fig. 9 zeigt insbesondere einen einlagigen Schichtaufbau auf dem Substrat (5). Die funktionellen Eigenschaften der Haftschicht (41) und/oder der Schutzschicht (42) werden lediglich durch eine Änderung der elementaren Zusammensetzung innerhalb dieser einlagigen Schicht erreicht. Typischerweise liegt der Kohlenstoffanteil in Elementprozent im Bereich der funktionellen Haftschicht (41) und/oder der funktionellen Schutzschicht (42) im Bereich von 10 - 30 Prozent. Bevorzugt ist ein Wert von etwa 20 Prozent. Der Kohlenstoffanteil im Bereich der funktionellen Barriereeigenschaften beträgt etwa 5 Elementprozent.

## Patentansprüche

1. Verfahren zur Plasmabehandlung von Werkstücken, bei dem das Werkstück in eine Plasmakammer eingesetzt wird und bei dem anschliessend bei Einwirkung eines Unterdruckes nach der Zündung eines Plasmas eine Beschichtung auf dem Werkstück abgeschieden wird sowie bei dem die Zündung des Plasmas durch gepulste Mikrowellenenergie erfolgt, wobei von einer Steuerung alternierend Einschaltphasen und Ausschaltphasen einer Mikrowelleneinkopplung vorgegeben werden, wobei während der Durchführung des Behandlungsvorganges für ein Werkstück (5) die Relation zwischen der Dauer der Einschaltphasen (44) und der Ausschaltphasen (45) verändert wird, **dadurch gekennzeichnet, dass** ein Quotient aus der Einschaltzeit (44) und der Ausschaltzeit (45) während der Dauer des Beschichtungsvorganges zunächst vergrössert und anschliessend wieder verkleinert wird, und ein Kohlenstoffanteil in einer Barriereschicht (40) ausgehend vom Werkstück (5) über die Schichtdicke (43) zunächst vermindert und in einem dem Werkstück (5) abgewandten Bereich wieder vergrössert wird.

2. Verfahren nach Anspruch 1, **dadurch gekennzeichnet, dass** mindestens während eines Teiles der Dauer der Plasmabehandlung die Dauer der Ausschaltzeit (45) zwischen zwei EinschaltZeiten (44} konstant gehalten wird.

3. Verfahren nach einem der Ansprüche 1 bis 2, **dadurch gekennzeichnet, dass** die Ausschaltzeit (45) 30 Millisekunden beträgt.

4. Verfahren nach einem der Ansprüche 1 bis 3, **dadurch gekennzeichnet, dass** die Einschaltzeit (44) zu einem Beginn der Plasmabehandlung 0,3 Millisekunden beträgt.

5. Verfahren nach einem der Ansprüche 1 bis 3, **dadurch gekennzeichnet, dass** die Einschaltzeit (44) zu einem Ende der Plasmabehandlung 0,3 Millisekunden beträgt.

6. Verfahren nach einem der Ansprüche 1 bis 5, **dadurch gekennzeichnet, dass** die Einschaltzeiten (44) während der Dauer des Behandlungsvorganges kontinuierlich vergrössert werden.

7. Verfahren nach einem der Ansprüche 1 bis 6, **dadurch gekennzeichnet, dass** als Werkstück (5) ein flaschenartiger Behälter mit der Barriereschicht (40) versehen wird.

8. Verfahren nach einem der Ansprüche 1 bis 7, **dadurch gekennzeichnet, dass** als Barriereschicht (40) eine Schicht verwendet wird, die SiOx enthält.

## Claims

1. A method for the plasma treatment of workpieces, in which the workpiece is inserted into a plasma chamber and in which, under the effect of negative pressure after ignition of a plasma, a coating is subsequently separated onto the workpiece, and in which the plasma is ignited by means of pulsed microwave energy, wherein a control alternately predetermines turn-on phases and turn-off phases of microwave injection, wherein
the relation between the duration of the turn-on phases (44) and the turn-off phases (45) is changed while the treatment process for a workpiece (5) is performed,
**characterised in that**
- a quotient of the turn-on time (44) and the turn-off time (45) is initially increased and subsequently reduced again for the duration of the coating process and, starting from the workpiece (5) and across the layer thickness (43), a portion of the carbon in a barrier layer (40) is initially reduced and then increased again in a region facing away from the workpiece (5).

2. The method in accordance with Claim 1, **characterised in that** the duration of the turn-off time (45) between two turn-on times (44) is kept constant for a part of the duration of the plasma treatment.

3. The method in accordance with any one of Claims 1 to 2, **characterised in that** the turn-off time (45) is 30 milliseconds.

4. The method in accordance with any one of Claims 1 to 3, **characterised in that** the turn-on time (44) is 0.3 milliseconds at the start of the plasma treatment.

5. The method in accordance with any one of Claims 1 to 3, **characterised in that** the turn-on time (44) is 0.3 milliseconds towards an end of the plasma treatment.

6. The method in accordance with any one of Claims 1 to 5, **characterised in that** the turn-on times (44) are continuously increased for the duration of the treatment process.

7. The method in accordance with any one of Claims 1 to 6, **characterised in that**, as a workpiece (5), a bottle-type container is provided with the barrier layer (40).

8. The method in accordance with any one of Claims 1 to 7, **characterised in that**, as a barrier layer (40), a layer containing SiOx is used.

## Revendications

1. Procédé de traitement au plasma de pièces dans le cadre duquel la pièce est introduite dans une chambre à plasma, après quoi, sous l'effet d'une dépression après l'amorçage d'un plasma, un revêtement est déposé sur la pièce, et dans le cadre duquel l'amorçage du plasma a lieu par énergie micro-ondes, des phases alternantes d'activation et de désactivation d'une injection de micro-ondes étant fixées par une commande et le rapport entre la durée des phases d'activation (44) et des phases de désactivation (45) étant modifié pendant l'exécution du processus de traitement d'une pièce (5), **caractérisé en ce qu'**un quotient du temps d'activation (44) par le temps de désactivation (45) est, pendant la durée du processus de revêtement, d'abord augmenté puis à nouveau réduit, et une proportion de carbone dans une couche formant barrière (40) est, dans l'épaisseur (43) de la couche partant de la pièce (5), d'abord réduite puis à nouveau augmentée dans une zone opposée à la pièce (5).

2. Procédé selon la revendication 1, **caractérisé en ce que**, pendant une partie au moins de la durée du traitement au plasma, la durée du temps de désactivation (45) entre deux temps d'activation (44) est maintenue constante.

3. Procédé selon l'une des revendications 1 à 2, **caractérisé en ce que** le temps de désactivation (45) est de 30 millisecondes.

4. Procédé selon l'une des revendications 1 à 3, **caractérisé en ce que** le temps d'activation (44) au début du traitement au plasma est de 0,3 millisecondes.

5. Procédé selon l'une des revendications 1 à 3, **caractérisé en ce que** le temps d'activation (44) à la fin du traitement au plasma est de 0,3 millisecondes.

6. Procédé selon l'une des revendications 1 à 5, **caractérisé par** une augmentation continue des temps d'activation (44) pendant la durée du processus de traitement.

7. Procédé selon l'une des revendications 1 à 6, **caractérisé en ce que** la pièce (5) dotée d'une couche formant barrière (40) est un récipient de type bouteille.

8. Procédé selon l'une des revendications 1 à 7, **caractérisé en ce que** la couche utilisée pour former barrière (40) est une couche contenant un oxyde de silicium SiOx.
